# EUROPEAN PATENT APPLICATION

(11) **EP 2 684 988 A1**
(43) Date of publication of application: **15.01.2014**
(21) Application number: 12755674.4
(22) Date of filing: 02.03.2012
(51) Int. Cl.: C30B 29/38, C23C 16/34, C30B 25/18, H01S 5/323

(54) **BASE, SUBSTRATE WITH GALLIUM NITRIDE CRYSTAL LAYER, AND PROCESS FOR PRODUCING SAME**

(30) Priority: 07.03.2011 JP 2011049487
(71) Applicant: Tokuyama Corporation, Shunan-shi, Yamaguchi 745-8648 (JP); Yamaguchi University, Yamaguchi 753-8511 (JP)
(72) Inventor: FURUYA, Hiroshi, Shunan-shi Yamaguchi 745-8648 (JP); AZUMA, Masanobu, Shunan-shi Yamaguchi 745-8648 (JP); TADATOMO, Kazuyuki, Ube-shi Yamaguchi 755-8611 (JP); OKADA, Narihito, Ube-shi Yamaguchi 755-8611 (JP)
(74) Representative: Duckworth, Timothy John
(86) International application number: PCT/JP2012/055407
(87) International publication number: WO 2012/121154

(57) **Abstract**

A GaN crystal multi-layer substrate having surfaces with various crystal orientations formed on a sapphire base substrate, such as a substrate whose principal surface is a <11-20> plane which is the a-plane, a <1-100> plane which is the m-plane, or a <11-22> plane having a low threading dislocation density and high crystal quality of a GaN crystal, and a production process therefor.

The gallium nitride crystal multi-layer substrate comprises a sapphire base substrate and a gallium nitride crystal layer which is formed on the substrate by crystal growth, wherein the gallium nitride crystal layer is formed by lateral crystal growth from sidewalls which are c-planes of a plurality of grooves formed in the principal surface of the sapphire base substrate in such a manner that the surface thereof is parallel to the principal surface of the base substrate and constituted of a nonpolar a-plane or m-plane or a semipolar <11-22> plane, and the dark-spot density of the gallium nitride crystal is less than 2 x 10⁸/cm², preferably not more than 1.85 x 10⁸/cm², particularly preferably not more than 1.4 x 10⁸/cm².

## Description

### Field of the Invention:

The present invention relates to a base substrate, a gallium nitride crystal multi-layer substrate, specifically, a multi-layer substrate having a gallium nitride (GaN) crystal layer with a low threading dislocation density on a sapphire base substrate, and a production process therefor.

### Prior Art:

A semiconductor light-emitting device having such a structure that an n-type GaN layer, multiple quantum well layers (MQWs) consisting of alternating quantum well layers composed of InGaN layers and barrier layers composed of GaN layers, and a p-type GaN layer are formed on a sapphire substrate in this order is mass-produced as a semiconductor light-emitting device such as a light emitting diode (LED) or a laser diode (LD). In this mass-produced semiconductor light-emitting device, GaN crystals are grown in the axial direction in all of the GaN layers and the orientations of the GaN layers are each a c-plane (<0001> plane).

In the GaN crystal layer whose surface is a c-plane, a Ga atomic plane containing only Ga atoms is charged positively whereas an N atomic plane containing only N atoms is slightly charged negatively with the result that spontaneous polarization is produced in the c-axis direction (thickness direction of the layer). When a different type of semiconductor layer is grown heteroepitaxially on the GaN crystal layer, compression strain or tensile strain is produced in the GaN crystal due to a difference in lattice constant between them, thereby producing piezoelectric polarization in the c-axis direction in the GaN crystal (refer to Patent Documents 1 and 2).

As a result, in the semiconductor light-emitting device having the above constitution, piezoelectric polarization produced by compression strain applied to the InGaN quantum well layer is superimposed on spontaneous polarization caused by fixed charge on the InGaN quantum well layer in the multi quantum well layer, thereby producing a large internal polarization electric field in the c-axis direction. It is considered that under the influence of this internal polarization electric field, there arises a problem such as the reduction of luminance efficiency and an emission peak wavelength shift caused by an increase in required injection current due to a quantum-confined stark effect (QCSE).

To solve the above problem, studies are being made to form an InGaN layer on an a-plane (<11-20> plane) or an m-plane (<1-100> plane) which is a nonpolar plane of a GaN crystal so as to eliminate the influence of an internal electric field produced by the superimposition of spontaneous polarization and piezoelectric polarization (refer to Patent Documents 1 to 3).

Further, studies are also being made to form an InGaN quantum well layer on a plane called "semipolar plane" in which the c-plane is inclined at about 60° in the a-axis or m-axis direction, for example, a semipolar <11-22> plane so as to eliminate the influence of an internal electrode (refer to non-Patent Documents 1 and 2).

However, it is said that a substrate having a nonpolar plane such as the a-plane or m-plane of the above currently available GaN crystal as the principal surface, or a substrate having a semipolar plane such as <11-22> plane or <10-11> plane as the principal surface has a threading dislocation density of 2 to 3 x 10⁸/cm², and a crystal substrate having a lower threading dislocation density and high crystal quality is desired.

### Prior Art Documents:

### Patent Documents:

Patent Document 1: JP-A 2008-53593
Patent Document 2: JP-A 2008-53594
Patent Document 3: JP-A 2007-243006

Non-Patent Documents:

Non-Patent Document 1: Japanese Journal of Applied Physics Vol. 45, 2006, L659
Non-Patent Document 2: Applied Physics Letters Vol. 90, 2007, 261912

### Summary of the Invention:

### Problem to Be Solved by the Invention:

It is an object of the present invention to provide a GaN crystal multi-layer substrate comprising a GaN crystal layer whose principal surface is a nonpolar plane or a semipolar plane formed on a sapphire base substrate, such as a substrate whose principal surface is the a-plane or m-plane of a GaN crystal having a low threading dislocation density and high crystal quality, or a substrate whose principal surface is a <11-22> plane or a <10-11> plane, a production process therefor and a sapphire base substrate used in the production process.

### Means for Solving the Problem:

The inventors of the present invention investigated a method of growing a GaN crystal having a desired crystal plane from the sidewalls of grooves formed in a sapphire base substrate by using the sapphire base substrate having a plurality of grooves. In this process, they found that the size of a crystal growth area on the sidewall of each of the grooves has a great influence upon crystal quality (threading dislocation density) but little upon the surface flatness of a grown crystal and crystallinity evaluated by X-ray diffraction measurement. The present invention was accomplished based on this finding.

That is, the present invention is a gallium nitride crystal multi-layer substrate comprising a sapphire base substrate and a gallium nitride crystal layer formed on the base substrate by crystal growth, wherein
the gallium nitride crystal layer is formed by lateral crystal growth from the sidewalls of a plurality of grooves formed in the principal surface of the sapphire base substrate in such a manner that the surface thereof is formed parallel to the principal surface, and the dark-spot density of the gallium nitride crystal is less than 2 x 10⁸/cm².

In the above gallium nitride crystal multi-layer substrate, preferably,
1) the dark-spot density of the gallium nitride crystal is not more than 1.4 x 10⁸/cm²,
2) the gallium nitride crystal layer has a surface with a nonpolar or semipolar orientation, and
3) the sidewalls which are the starting points of lateral crystal growth from the grooves are each the c-plane of a sapphire single crystal.

Another invention is a process for producing a gallium nitride crystal multi-layer substrate, comprising the steps of:
forming a plurality of grooves, each having sidewalls inclined with respect to the principal surface of a sapphire base substrate, in the sapphire base substrate; and
laterally growing a gallium nitride crystal selectively from the sidewalls of the grooves, wherein
the width (d) of an area for growing a gallium nitride crystal on the sidewalls is set to 10 to 750 nm.

In the above process for producing a gallium nitride crystal multi-layer substrate, preferably,
4) the width (d) of the area for growing a gallium nitride crystal is 100 to 200 nm, and
5) the sidewalls which are the starting points of lateral crystal growth from the grooves are each the c-plane of a sapphire single crystal.

Further, still another invention is a sapphire base substrate for manufacturing a crystal multi-layer substrate, wherein the sapphire base substrate has a plurality of grooves, each having sidewalls inclined with respect to the principal surface thereof, and the width (d) of an area for growing a gallium nitride crystal selectively on sidewalls of the grooves is set to 10 to 750 nm.

In the above sapphire base substrate for manufacturing a crystal multi-layer substrate, preferably,
6) the width (d) of the area for growing a gallium nitride crystal is 100 to 200 nm; and
7) the sidewalls which are the starting points of lateral crystal growth from the grooves are each the c-plane of a sapphire single crystal.

### Effect of the Invention:

Since the gallium nitride crystal multi-layer substrate of the present invention has high crystal quality with a dark-spot density of a gallium nitride crystal of less than 2 x 10⁸/cm², preferably not more than 1.85 x 10⁸/cm², particularly preferably not more than 1.4 x 10⁸/cm², a semiconductor light-emitting device such as LED or LD manufactured by using this multi-layer substrate has improved luminance efficiency.

By growing a gallium nitride crystal selectively from sidewalls of grooves formed in the sapphire base substrate, a high-quality gallium nitride crystal having a nonpolar or semipolar plane as the principal surface is obtained. Therefore, a semiconductor light-emitting device manufactured by using this is rarely affected by the reduction of luminance efficiency caused by a quantum-confined stark effect as compared with a conventional gallium nitride multi-layer substrate having a c-plane as the principal surface.

### BRIEF DESCRIPTION OF THE INVENTION:

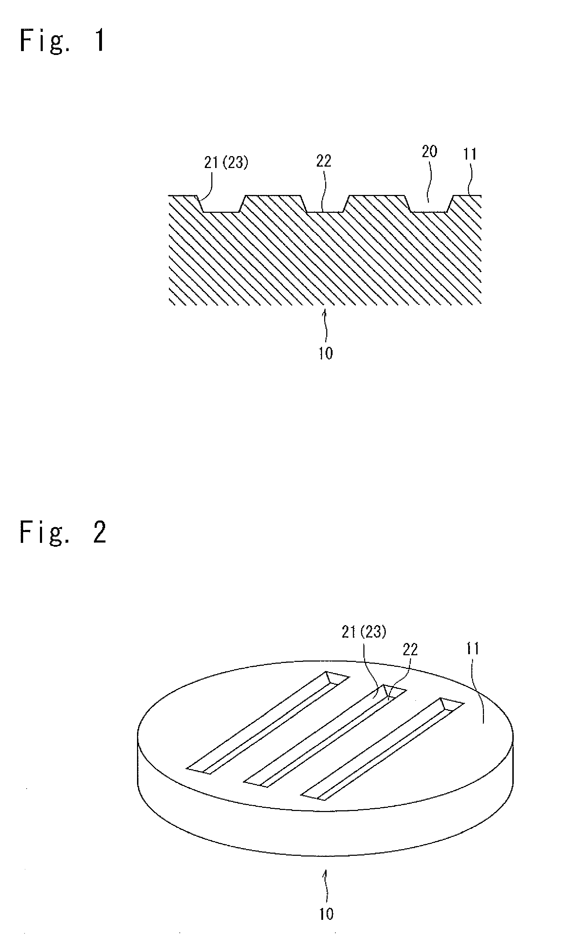

Fig. 1 is a partial sectional view of the sapphire base substrate of the present invention;
Fig. 2 is a diagram showing an example of the sapphire base substrate of the present invention;
Fig. 3 is an enlarged sectional view of a groove in the sapphire base substrate;
Fig. 4 is an enlarged perspective view of a groove in the sapphire base substrate having masking parts;
Fig. 5 is a diagram typically showing the process of growing GaN crystals on the base substrate;
Fig. 6 is a diagram typically showing a sapphire base substrate and the state of the obtained GaN crystal layer; and
Fig. 7 is a graph showing the relationship between the width (d) of the sidewall and dark-spot density.

### BEST MODE FOR CARRYING OUT THE INVENTION:

The gallium nitride crystal multi-layer substrate of the present invention comprises (1) a sapphire base substrate as a lower layer which has a plurality of grooves, each having sidewalls inclined with respect to the principal surface of the base substrate, and a growth area having a width (d) of 10 to 750 nm for growing a gallium nitride crystal on the sidewalls of the grooves and (2) a gallium nitride crystal layer which is formed on the base substrate by epitaxial lateral overgrowth (ELO) from the sidewalls and has a surface parallel to the above principal surface and a dark-spot density of less than 2 x 10⁸/cm².

The term "dark-spot density" is a physical property value indicative of the density of threading dislocations which are the dislocation defects of a crystal and measured by using a scanning electron microscope/cathode luminescence (SEM·CL) apparatus. A measurement sample having an n-type GaN crystal layer on an unintentionally doped GaN crystal layer is used to measure the surface of the n-type GaN layer. The acceleration voltage at the time of measurement is 5 kV, and the observation range is 20 µm x 20 µm. At this spot, the dark-spot density is calculated from the total number of dark spots seen within the observation range.

The sapphire base substrate for manufacturing the crystal multi-layer substrate of the present invention has a plurality of grooves, each having sidewalls inclined with respect to the principal surface of the substrate, and the width (d) of an area for growing a gallium nitride crystal selectively on the sidewalls of the grooves is set to 10 to 750 nm.

A sapphire substrate having the principal surface in a specific crystal orientation is used as the above base substrate. However, to obtain a desired GaN crystal which will be described hereinafter, the principal surface may be a miscut surface inclined at a predetermined angle with respect to the crystal axis.

The base substrate is generally a disk-like substrate having a thickness of 0.3 to 3.0 mm and a diameter of 50 to 300 mm.

The principal surface of the sapphire base substrate has an arbitrary crystal orientation in accordance with the crystal plane of a GaN crystal of interest. For example, to grow a GaN crystal having a <11-22> plane as the surface thereof, the principal surface of the sapphire base substrate should be a <10-12> plane. To grow a GaN crystal having a <10-11> plane as the surface thereof, the principal surface of the sapphire base substrate should be a <11-23> plane. Besides these, a <10-11> plane, a <11-20> plane or a <20-21> plane can be the principal surface.

For example, when a sapphire substrate having a <10-12> plane as the principal surface is used and the c-plane of a sapphire single crystal (to be referred to as "sapphire c-plane" hereinafter) is formed on part of the sidewall of a groove, the angle between the sapphire c-plane and the principal surface of the sapphire substrate is 57.6° . However, since the angle between the <11-22> plane of a GaN crystal of interest and the c-plane of the GaN crystal is 58.4° , a GaN crystal layer having a <11-22> plane inclined at 0.8° with respect to the sapphire principal surface is grown on the sapphire substrate having a <10-12> plane as the principal surface. To offset this angle, a miscut substrate whose surface is obtained by adding an offset angle to the <10-12> plane is used so that the <11-12> plane which is the surface of the GaN crystal layer can be grown parallel to the principal surface of the sapphire substrate. Various miscut substrates which are designed to make the surface of a GaN crystal layer parallel to the principal surface of a sapphire base substrate can be used according to the orientation of a GaN crystal of interest and the crystal orientation of the sapphire base substrate in use.

A plurality of grooves are formed parallel to one another in the principal surface of the sapphire base substrate. The width of the opening of each of the grooves is not particularly limited and generally selected from a range of 0.5 to 10 µm. The interval between grooves, that is, the interval on the principal surface line of the base substrate between adjacent grooves is 1 to 100 µm. The width in the lateral direction of the bottom of each groove, that is, the distance (w) in a direction perpendicular to the extension direction of the groove is not particularly limited and generally 1 to 100,000 µm.

The number of the grooves in the principal surface may be set according to a desired area of a GaN crystal to be formed but generally 10 to 500 per 1 mm in consideration of the width of the above opening, the interval between grooves and the width of the bottom.

Each of the above grooves has sidewalls inclined at a predetermined angle with respect to the principal surface of the base substrate.

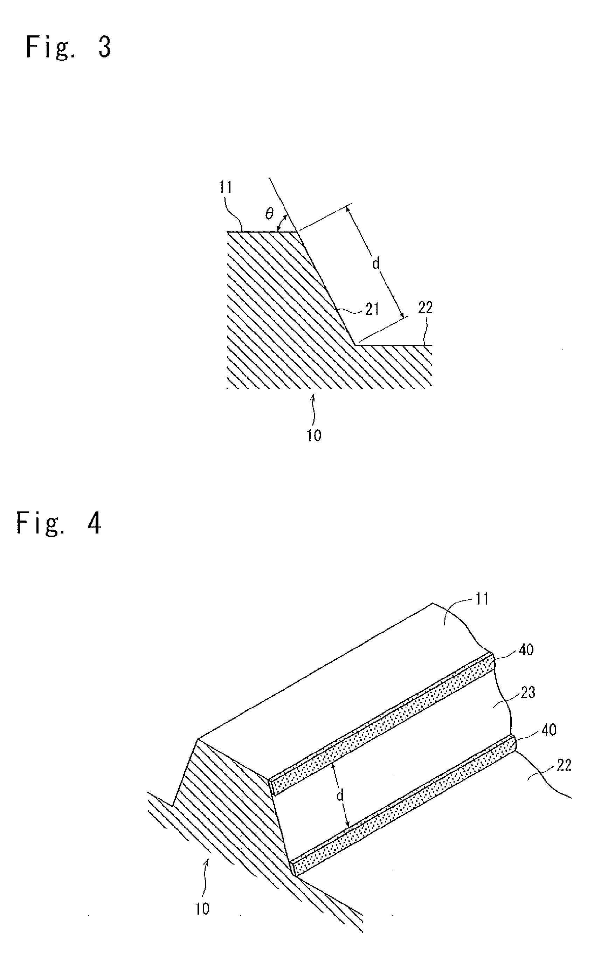

As shown in Fig. 3, as for the sectional form of the groove, the groove is tapered such that the width of the groove is narrowed from the opening toward the bottom of the groove.

As shown in Fig. 3, the inclination angle means an angle (θ) between the principal surface of the base substrate and the extension plane of the sidewall of the groove. This angle is determined in consideration of the crystal orientation of a GaN crystal to be formed in accordance with the crystal orientation of the principal surface of the base substrate.

For example, when the crystal orientation of the principal surface of the sapphire base substrate is a <10-12> plane and the crystal orientation of a desired GaN crystal is a <11-22> plane, the GaN crystal is grown from this sidewall based on the condition that this angle is 58.4° so that the c-axis of the GaN crystal becomes the same in direction as the c-axis of the sapphire base substrate so as to obtain a desired crystal.

This angle 58.4° is determined based on the fact that the angle between the <11-22> plane which is the principal surface of the desired GaN crystal and the c-plane of the GaN crystal which is perpendicular to the c-axis of the GaN crystal as the growth direction is 58.4° . However, since the angle between the <10-12> plane which is the principal surface of the sapphire base substrate in use and the sapphire c-plane which appears on the sidewall of the groove is 57.6° , the angle (θ) between the principal surface of the base substrate and the sidewall of the groove is 57.6° , and the surface of a GaN crystal layer grown thereon is inclined at about 0.8° with respect to the principal surface of the sapphire base substrate. Then, by using a miscut substrate whose principle surface is obtained by adding an offset angle to the sapphire <10-12> plane to offset this angle, a GaN crystal layer in which the <11-22> plane of the GaN crystal is parallel to the principal surface of the sapphire base substrate can be obtained.

When the crystal orientation of the principal surface of the sapphire base substrate is a <11-23> plane and the crystal orientation of a desired GaN crystal is a <10-11> plane, the GaN crystal is grown from this sidewall based on the condition that this angle to 62.0° so that the c-axis of the GaN crystal becomes the same in direction as the c-axis of the sapphire base substrate so as to obtain a desired crystal.

This angle 62.0° is determined based on the fact that the angle between the <10-11> plane which is the principal surface of the desired GaN crystal and the c-plane of the GaN crystal which is perpendicular to the c-axis of the GaN crystal as the growth direction is 62.0°. However, since the angle between the <11-23> plane which is the principal surface of the sapphire base substrate in use and the sapphire c-plane which appears on the sidewall of the groove is 61.2° , the angle (θ) between the principal surface of the base substrate and the sidewall of the groove is 61.2° , and the surface of a GaN crystal layer grown thereon is inclined at about 0.8° with respect to the principal surface of the sapphire base substrate. Then, by using a miscut substrate whose principle surface is obtained by adding an offset angle to the sapphire <11-23> plane to offset this angle, a GaN crystal layer in which the <10-11> plane of the GaN crystal is parallel to the principal surface of the sapphire base substrate can be obtained.

When the crystal orientation of the principal surface of the sapphire base substrate is a <11-20> plane and the crystal orientation of a desired GaN crystal is a <10-10> plane, the GaN crystal is grown from this sidewall based on the condition that this angle is 90° so that the c-axis of the GaN crystal becomes the same in direction as the c-axis of the sapphire base substrate so as to obtain a desired crystal.

This angle 90° is determined based on the fact that the angle between the <11-20> plane which is the principal surface of the desired GaN crystal and the c-plane of the GaN crystal which is perpendicular to the c-axis of the GaN crystal as the growth direction is 90°. However, in the etching step for forming grooves in the sapphire substrate, etching proceeds not only in a direction perpendicular to the principal surface of the sapphire substrate but also in directions other than the perpendicular direction, including a parallel direction, thereby making it technically difficult to form grooves having sidewalls which are truly perpendicular to the principal surface of the sapphire substrate. By using a sapphire substrate having grooves with an angle (θ) between the principal surface of the base substrate and the sidewall of each groove close to 90°, a GaN crystal layer which is grown on the sapphire base substrate having a <11-20> plane as the principal surface in such a manner that the <10-10> plane of a GaN crystal becomes parallel to the principal surface of the sapphire base substrate can be obtained.

When the crystal orientation of the principal surface of the sapphire base substrate is a <10-10> plane and the crystal orientation of a desired GaN crystal is a <11-20> plane, the GaN crystal is grown from this sidewall based on the condition that this angle is 90° so that the c-axis of the GaN crystal becomes the same in direction as the c-axis of the sapphire base substrate so as to obtain a desired crystal.

This angle 90° is determined based on the fact that the angle between the <10-10> plane which is the principal surface of the desired GaN crystal and the c-plane of the GaN crystal which is perpendicular to the c-axis of the GaN crystal as the growth direction is 90°. However, it is technically difficult to form grooves having an angle (θ) between the principal surface of the base substrate and the sidewall of the groove of 90° as described above. By using a sapphire substrate having grooves with an angle (θ) between the principal surface of the base substrate and the sidewall of the groove close to 90°, a GaN crystal layer which is grown on the sapphire base substrate having a <10-10> plane as the principal surface in such a manner that the <11-20> plane of the GaN crystal becomes parallel to the principal surface of the sapphire base substrate can be obtained.

When the crystal orientation of the principal surface of the sapphire base substrate is a <0001> plane and the crystal orientation of a desired GaN crystal is a <10-10> plane, the GaN crystal is grown from this sidewall based on the condition that this angle is 90° so that the c-axis of the GaN crystal becomes the same in direction as the a-axis of the sapphire base substrate so as to obtain a desired crystal.

This angle 90° is determined based on the fact that the angle between the <10-10> plane which is the principal surface of the desired GaN crystal and the c-plane of the GaN crystal which is perpendicular to the c-axis of the GaN crystal as the growth direction is 90°. However, it is technically difficult to form grooves having an angle (θ) between the principal surface of the base substrate and the sidewall of the groove of 90° as described above. By using a sapphire substrate having grooves with an angle (θ) between the principal surface of the base substrate and the sidewall of the groove close to 90° , a GaN crystal layer which is grown on the sapphire base substrate having a <0001> plane as the principal surface in such a manner that the <10-10> plane of the GaN crystal becomes parallel to the principal surface of the sapphire base substrate can be obtained.

In the present invention, the setting of the width (d) of an area for growing a GaN crystal on the sidewall of the above groove (to be referred to as "crystal growth area" hereinafter) is extremely important for the reduction of the threading dislocation density.

The term "width (d) of the crystal growth area" refers to the shortest distance (interval) on the sidewall between a side where the principal surface of the base substrate intersects the sidewall and a side where the sidewall intersects the bottom of the groove when the total area of the sidewall as the starting point of growth is the crystal growth area as shown in Fig. 3.

When part of the sidewall is masked to limit the crystal growth area as shown in Fig. 4, the width is a distance (d) obtained by removing the widths of the masking parts from the above shortest distance (interval).

In the present invention, the width (d) must be set to 10 to 750 nm in order to obtain a dark-spot density of less than 2 x 10⁸/cm². Especially, to set the dark-spot density to less than 1.4 x 10⁸/cm², the width (d) must be set to 100 to 200 nm. The lower limit value of the width (d) is not particularly limited and preferably as small as possible. However, it is determined from technical restrictions at the time of forming grooves which will be described hereinbelow.

The grooves having sidewalls with the above predetermined inclination angle can be formed by forming a photoresist patterning by which only groove forming portions become openings and carrying out the dry etching such as reactive ion etching (RIE) or wet etching of the sapphire base substrate with a photoresist as an etching resist.

Further, the coating amount of the photoresist, baking temperature, baking time, the dose of UV exposure and the shape of a photomask for UV exposure are means of controlling the width of the sidewall, the width of the opening of the groove, the interval between grooves and the width of the bottom in the step of forming a photoresist patterning. In the etching step, they can also be controlled by the type of an etching gas, the concentration of the etching gas, the mixing ratio of etching gases, antenna power, bias power and etching time.

By combining these conditions, a sapphire base substrate having grooves of a predetermined shape can be obtained. The width of the sidewall which is particularly important in the present invention can be controlled by obtaining the etching rate which is the rate of etching sapphire per unit time and changing the etching time.

A base substrate having sidewalls with various crystal orientations can be manufactured by selecting the principal surface of a sapphire base substrate and setting the extension direction of the grooves in the above method.

Stated more specifically, when the principal surface of the base substrate is a <10-12> plane and the extension direction of the groove is the direction of a <11-20> plane, that is, the a-axis direction, the c-plane is exposed to the sidewall which is the crystal growth surface. When the principal surface of the base substrate is a <11-23> plane and the extension direction of the groove is the direction of a <10-10> plane, that is, the m-axis direction, the c-plane is exposed to the sidewall which is the crystal growth surface. When the principal surface of the base substrate is a <11-20> plane and the extension direction of the groove is the direction of a <10-10> plane, that is, the m-axis direction, the c-plane is exposed to the sidewall which is the crystal growth surface. When the principal surface of the base substrate is a <10-10> plane and the extension direction of the groove is the direction of a <11-20> plane, that is, the a-axis direction, the c-plane is exposed to the sidewall which is the crystal growth surface. When the principal surface of the base substrate is a <0002> plane and the extension direction of the groove is the direction of a <10-10> plane, that is, the m-axis direction, the a-plane is exposed to the sidewall which is the crystal growth surface.

As described above, the crystal orientation of the principal surface of the sapphire base substrate and the crystal orientation of the sidewall which is the starting point of crystal growth can be arbitrarily designed. Lateral growth from the c-plane sidewall out of sidewalls having various crystal orientations readily occurs preferentially and is easy to be controlled. Therefore, it is preferred that a c-plane sidewall should be formed on at least part of the sidewall constituting the groove.

As means of masking part of the sidewall, there is a masking method in which a SiO₂ film, SiNₓ film, TiO₂ film or ZrO₂ film is formed in an area except for the crystal growth area by vacuum deposition, sputtering or CVD (chemical vapor deposition). The thickness of the masking layer is generally 0.01 to 3 µm.

The GaN crystal layer is formed by ELO from the above sidewall in such a manner that the surface thereof is formed on the sapphire base substrate in parallel to the principal surface of the base substrate. The thickness of the formed GaN crystal layer (height from the principal surface of the sapphire base substrate) is not particularly limited but generally 2 to 20 µm.

The crystal orientation of the crystal surface of the GaN crystal layer is a <11-22> plane, a <10-11> plane or a <20-21> plane according to the principal surface of the sapphire base substrate as described above.

The method of growing a GaN crystal is not particularly limited, and metal organic vapor phase epitaxy (MOVPE), molecular beam epitaxy (MBE) and hydride vapor phase epitaxy (HVPE) are employed, out of which organic vapor phase epitaxy is the most common. The growing method making use of metal organic vapor epitaxy will be described hereinbelow. The technology described in WO2010/023846 proposed by the inventors of the present invention can be applied correspondingly without restrictions.

Roughly speaking, an MOVPE apparatus used for crystal growth comprises a substrate conveyor system, a substrate heating system, a gas supply system and a gas exhaust system all of which are electronically controlled. The substrate heating system comprises a thermocouple, a resistive heater and a carbon or SiC suscepter formed on the heater, and a quartz tray on which the sapphire base substrate of the present invention has been set is carried onto the suscepter to carry out the epitaxial growth of a semiconductor layer. This substrate heating system is installed in a quartz double-tube or a stainless reactor equipped with a water cooling mechanism, and a carrier gas and raw material gases are supplied into the double tube or the reactor. Particularly when the stainless reactor is used, to create a gas laminar flow over the substrate, a quartz flow channel is used.

H₂ and N₂ are used as the carrier gas. NH₃ is used as a nitrogen element supply source. Trimethyl gallium (TMG) is used as a Ga element supply source.

A description is subsequently given of the formation of a GaN crystal layer. The sapphire base substrate is first set on the quartz tray in such a manner that the principal surface of the substrate faces up and heated at 1,050 to 1,150°C while the inside pressure of the reactor is set to 10 to 100 kPa, H₂ is circulated as a carrier gas in the flow channel installed in the reactor, and this state is maintained for several minutes to thermally clean the sapphire base substrate.

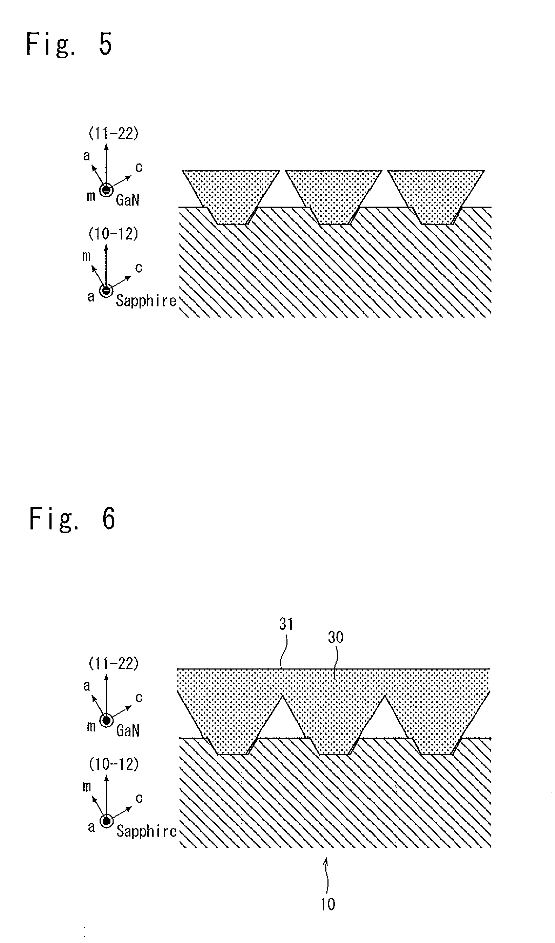

Then, the temperature of the sapphire base substrate is raised to 1,050 to 1,150°C while the inside pressure of the reactor is set to 10 to 100 kPa, and NH₃ and TMG are supplied into the reactor at rates of 0.1 to 5 L/min and 10 to 150 µmol/min, respectively, while the H₂ carrier gas is circulated in the reactor at a rate of 10 L/min. At this point, as shown in Fig. 5, undoped GaN is heteroepitaxially grown from the sidewalls of the grooves in the sapphire base substrate. This crystal growth develops the growth of a GaN layer in the normal direction of the principal surface of the substrate to form a GaN crystal layer on the sapphire base substrate as shown in Fig. 6, thereby obtaining a multi-layer substrate. The thickness of the GaN crystal layer is about 2 to 20 µm. It is preferred that before the GaN crystal layer is formed, a low-temperature buffer layer having a thickness of 20 to 30 nm should be formed on the crystal growth area of the sidewall.

For the crystal growth of a GaN crystal by using the sapphire base substrate of the present invention, to control such that growth should take place from the sidewalls of the grooves preferentially without causing growth from the principal surface of the substrate, it is necessary to optimize various conditions such as the growth temperature, the growth pressure, the raw material gas feed rates, the raw material gas supply ratio, the type of the carrier gas and the amount of the carrier gas. After the growing method, the reactor and the raw materials in use are determined, these conditions should be determined in advance through preliminary experiments. The sapphire base substrate used in the present invention may have a surface except for the crystal growth area, for example, a principal surface covered with a crystal growth inhibiting layer composed of SiO₂ and the like. The formation of the crystal growth inhibiting layer makes it possible to control such that growth from the principal surface of the substrate is suppressed and growth from the sidewalls of the grooves takes place preferentially.

Stated more specifically, when the principal surface of the base substrate is a <10-12> plane or a <11-23> plane, a GaN crystal may grow from the principal surface of the base substrate, a sidewall of the groove from which the sapphire c-plane is exposed and the other sidewall of the groove. In this case, to control such that the GaN crystal should grow preferentially from the sidewall of the groove from which the sapphire c-plane is exposed, it is necessary to optimize the above growth conditions. Growth from the principal surface of the base substrate can also be suppressed by forming a crystal growth inhibiting layer.

When the principal surface of the base substrate is a <11-20> plane, a <10-10> plane or a <0002> plane, a GaN crystal may grow from the principal surface of the base substrate and from the sidewalls of the groove. Since the sidewalls on both sides of the groove have the same crystal orientation, GaN crystals having the same crystal orientation grow from both of the sidewalls, it is therefore unnecessary to control such that a crystal should grow from any one of the sidewalls, and growth from the principal surface of the base substrate should be suppressed. To suppress growth from the principal surface of the base substrate, the formation of a crystal growth inhibiting layer is effective but the above growth can be controlled only by the optimization of the above growth conditions.

The GaN crystal layer is composed of an aggregate of a plurality of belt-like GaN crystals which grow from the growth area of the sidewall of the groove, or an integrated unit formed of an assembly of belt-like GaN crystals.

The crystal orientation of the surface of the obtained GaN crystal layer differs according to the crystal structure of the sapphire base substrate. For example, when the principal surface of the sapphire base substrate is a <10-12> plane and the sidewall which is the starting point of growth is a c-plane, a GaN crystal whose m-axis is parallel to the a-axis of sapphire and whose a-axis is parallel to the m-axis of sapphire is grown on the sidewall. As a result, a GaN crystal layer which is grown in such a manner that the <11-22> plane of the GaN crystal becomes parallel to the principal surface of the sapphire base substrate is formed on the sapphire base substrate.

Alternatively, when the principal surface of the sapphire base substrate is a <11-23> plane and the sidewall which is the starting point of growth is a c-plane, a GaN crystal whose a-axis is parallel to the m-axis of sapphire and whose m-axis is parallel to the a-axis of sapphire is grown on the sidewall. As a result, a GaN crystal layer which is grown in such a manner that the <10-11> plane of the GaN crystal becomes parallel to the principal surface of the sapphire base substrate is formed on the sapphire base substrate.

Gallium nitride crystal multi-layer substrates obtained by the above various growth methods can be used directly as substrates for various semiconductor emitting devices.

### EXAMPLES:

The following examples are provided for the purpose of further illustrating the present invention but are in no way to be taken as limiting. All combinations of characteristic features described in the examples are not always essential to the means for solving the problem in the present invention.

### Example 1

### [manufacture of sapphire base substrate]

A resist was stripe-patterned on a <10-12> plane sapphire base substrate and dry etched by reactive ion etching (RIE) to form a plurality of grooves in the sapphire base substrate. The grooves had an opening width of 3 µm, a depth of 100 nm and a width on the principal surface of the substrate between adjacent grooves of 3 µm. The inclination angle of the sidewall was about 60°, and the width (d) of the sidewall calculated from the depth of the groove and the inclination angle of the sidewall was 115 nm.

After dry etching, the resist was removed by washing to obtain a sapphire base substrate. This sapphire base substrate had 8466 grooves in the principal surface. Each of the grooves consisted of a sidewall which is a sapphire c-plane as a crystal growth area, a sidewall in another crystal orientation and a bottom.

### [formation of undoped GaN crystal layer]

After the manufactured sapphire base substrate was set on a quartz tray in a MOVPE apparatus in such a manner that the front side of the substrate faced up, the substrate was heated at 1,150°C while the inside pressure of the reactor was set to 100 kPa, H₂ as a carrier gas was circulated in the reactor at a rate of 10 L/min, and this state was kept for 10 minutes to thermally clean the substrate.

Then, the temperature of the substrate was set to 460°C while the inside pressure of the reactor was set to 100 kPa, and a group V element supply source (NH₃) and a group III element supply source (TMG) were supplied at rates of 5 L/min and 5.5 µmol/min, respectively, while the H₂ carrier gas was circulated in the reactor at a rate of 5 L/min so as to deposit about 25 nm of amorphous GaN on the substrate. Subsequently, the temperature of the substrate was set to 1,075°C while the inside pressure of the reactor was set to 20 kPa, and the H₂ carrier gas was circulated in the reactor at a rate of 5 L/min to recrystallize GaN deposited on the substrate so as to form a GaN crystal nucleus selectively in the crystal growth area of the sidewall of the groove.

Then, the temperature of the base substrate was set to 1, 075°C while the inside pressure of the reactor was set to 20 kPa, the group V element supply source (NH₃) and the group III element supply source (TMG) were flown at rates of 2 L/min and 30 µmol/min for 30 minutes, respectively, while the H₂ carrier gas was circulated in the reactor at a rate of 5 L/min to grow GaN (undoped GaN) crystals on the GaN crystal nucleus, thereby forming a GaN crystal layer such that the crystals were laterally grown from the sidewall of the groove in the base substrate.

Thereafter, the temperature of the base substrate was set to 1, 025°C while the inside pressure of the reactor was set to 20 kPa, the group V element supply source (NH₃) and the group III element supply source (TMG) were flown at rates of 2 L/min and 30 µmol/min for 300 minutes, respectively, while the H₂ carrier gas was circulated in the reactor at a rate of 5 L/min to grow GaN crystals, whereby the GaN crystals grown from the sidewall of each of the grooves in the base substrate were assembled together to form a GaN crystal layer such that its surface which is a <11-22> plane of the GaN crystal is parallel to the principal surface of the base substrate.

### [formation of n-type GaN crystal layer]

Thereafter, the temperature of the base substrate was set to 1,025°C while the inside pressure of the reactor was set to 20 kPa, the group V element supply source (NH₃), the group III element supply source (TMG) and an n-type doping element supply source (SiH₄) were flown at rates of 2 L/min, 30 µmol/min and 5.8 x 10⁻³ µmol/min for 60 minutes, respectively, while the H₂ carrier gas was circulated in the reactor at a rate of 5 L/min to form an n-type GaN crystal layer by epitaxial growth in the same crystal orientation as the undoped GaN crystal layer on the undoped GaN crystal layer.

### Example 2

A GaN crystal layer was formed on the sapphire base substrate in the same manner as in Example 1 except that the depth of each of the grooves formed in the sapphire base substrate was set to 200 nm and the width (d) of the sidewall was set to 231 nm.

### Example 3

A GaN crystal layer was formed on the sapphire base substrate in the same manner as in Example 1 except that the depth of each of the grooves formed in the sapphire base substrate was set to 500 nm and the width (d) of the sidewall was set to 577 nm.

### Comparative Example 1

A GaN crystal layer was formed on the sapphire base substrate in the same manner as in Example 1 except that the depth of each of the grooves formed in the sapphire base substrate was set to 1 µm and the width (d) of the sidewall was set to 1155 nm.

### [evaluation of dark-spot density]

As for the GaN crystal layers obtained in Examples 1 to 3 and Comparative Example 1, the surfaces of the n-type GaN crystal layers were observed through a scanning electron microscope/cathode luminescence (SEM·CL) apparatus. When the acceleration voltage was set to 5 kV and the observation range was set to 20 µm x 20 µm so as to calculate the dark-spot density from the total number of dark spots seen in the observation range, the results shown in Table 1 were obtained.

**Table 1**

| | Groove depth (nm) | width of sidewall (d) (nm) | dark-spot density 2 (per cm²) |
|---|---|---|---|
| Example 1 | 100 | 115 | 1.36 × 10⁸ |
| Example 2 | 200 | 231 | 1.85 × 10⁸ |
| Example 3 | 500 | 577 | 1.95 × 10⁸ |
| Comp. Ex. 1 | 1000 | 1155 | 2.18 × 10⁸ |

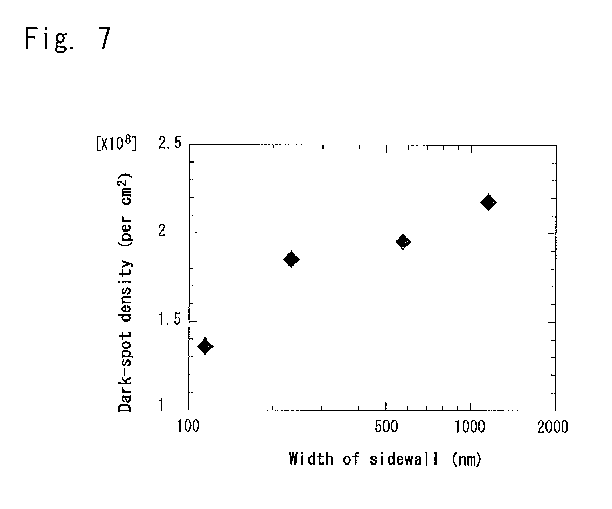

The relationship between the width (d) of the sidewall and the dark-spot density which was obtained from the data of the above Examples 1 to 3 and Comparative Example 1 is shown in Fig. 7 (X axis shows logarithms). It is understood from this figure that when the width (d) of the sidewall of the base substrate is set to not more than 750 nm, a GaN crystal layer having a <11-22> plane orientation with a dark-spot density of less than 2 x 10⁸/cm² is obtained and particularly when the width (d) is set to not more than 200 nm, a GaN crystal layer having high crystal quality with a dark-spot density of not more than 1.85 x 10⁸/cm² is obtained. It can be confirmed that the width (d) of the sidewall which is the crystal growth area greatly contributes to crystal quality.

### Explanation of reference numerals

- 10: sapphire base substrate
- 11: principal surface of base substrate
- 20: groove in base substrate
- 21: sidewall of groove
- 22: bottom of groove
- 23: crystal growth area of sidewall
- 30: GaN crystal layer
- 31: surface of GaN crystal layer
- 40: masking part

## Claims

1. A gallium nitride crystal multi-layer substrate comprising a sapphire base substrate and a gallium nitride crystal layer which is formed by crystal growth on the substrate, wherein
the gallium nitride crystal layer is formed by lateral crystal growth from the sidewalls of a plurality of grooves formed in the principal surface of the sapphire base substrate in such a manner that the surface thereof is parallel to the principal surface, and the dark-spot density of the gallium nitride crystal is less than 2 x 10⁸/cm².

2. The gallium nitride crystal multi-layer substrate according to claim 1, wherein the dark-spot density of the gallium nitride crystal is not more than 1.4 x 10⁸/cm².

3. The gallium nitride crystal multi-layer substrate according to claim 1 or 2, wherein the gallium nitride crystal layer has a surface with a nonpolar or semipolar orientation.

4. The gallium nitride crystal multi-layer substrate according to any one of claims 1 to 3, wherein the sidewalls which are the starting points of lateral crystal growth are each the c-plane of a sapphire single crystal.

5. A process for manufacturing a gallium nitride crystal multi-layer substrate, comprising the steps of:
forming a plurality of grooves, each having sidewalls inclined with respect to the principal surface of a sapphire base substrate, in the sapphire base substrate; and
laterally growing a gallium nitride crystal selectively from the sidewalls of the grooves, wherein
the width (d) of an area for growing a gallium nitride crystal on the sidewalls is set to 10 to 750 nm.

6. The process for manufacturing a gallium nitride crystal multi-layer substrate according to claim 5, wherein the width (d) of the area for growing a gallium nitride crystal is 100 to 200 nm.

7. The process for manufacturing a gallium nitride crystal multi-layer substrate according to claim 5 or 6, wherein the sidewalls which are the starting points of lateral crystal growth are each the c-plane of a sapphire single crystal.

8. A sapphire base substrate for manufacturing a crystal multi-layer substrate, wherein the sapphire base substrate has a plurality of grooves, each having sidewalls inclined with respect to the principal surface thereof, and the width (d) of an area for growing a gallium nitride crystal selectively on the sidewalls of the grooves is set to 10 to 750 nm.

9. The sapphire base substrate for manufacturing a crystal multi-layer substrate according to claim 8, wherein the width (d) of the area for growing a gallium nitride crystal is 100 to 200 nm.

10. The sapphire base substrate for manufacturing a crystal multi-layer substrate according to claim 8 or 9, wherein the sidewalls which are the starting points of lateral crystal growth are each the c-plane of a sapphire single crystal.
